# EUROPEAN PATENT APPLICATION

(11) **EP 4 514 075 A1**
(43) Date of publication of application: **26.02.2025**
(21) Application number: 23936785.7
(22) Date of filing: 13.06.2023
(51) Int. Cl.: H05K 1/09, H05K 3/38, G06K 19/077

(54) **CIRCUIT BOARD AND CHIP PACKAGE COMPRISING SAME**

(71) Applicant: LG INNOTEK CO., LTD., Seoul 07796 (KR)
(72) Inventor: ROH, Myoung Lae, Seoul 07796 (KR); KIM, Kab Young, Seoul 07796 (KR); JO, Min Sung, Seoul 07796 (KR)
(74) Representative: DREISS Patentanwälte PartG mbB
(86) International application number: PCT/KR2023/008142
(87) International publication number: WO 2024/257909

(57) **Abstract**

A circuit board according to an embodiment comprises a first metal layer; and a second metal layer disposed on the first metal layer, wherein the first metal layer includes an oxide layer formed by oxidizing a region at a predetermined depth from a lower surface of the first metal layer, the first metal layer and the second metal layer include a plurality of electrode patterns disposed on the oxide layer and spaced apart from each other, and the oxide layer insulates between the plurality of electrode patterns.

## Description

### [Technical Field]

An embodiment relates to a circuit board, and more particularly to a circuit board applied to a smart IC and a chip package including the same.

### [Background Art]

A smart IC card is a card with at least one integrated circuit chip or chip module embedded therein. More specifically, the smart IC card is generally made of plastic resin in a shape of a thin card. In addition, the smart IC card has a central processing unit such as a microprocessor that can process information as well as input and output information without a separate power source on the card, and a memory device to store a certain amount of information. The smart IC card refers to a device capable of performing simple operations by itself. In order to implement such a smart IC card, a chip package and a card body on which the chip package is mounted are required. In this case, the chip package includes a thin semiconductor chip mounted on a circuit pattern of a printed circuit board, and a contact terminal that allows a circuit pattern electrically connected to a semiconductor chip on an opposite side of a printed circuit board to be connected in a contact or non-contact manner to an external card reader, etc.

The above-mentioned smart IC cards are widely used in various fields such as credit cards, SIM cards, security cards, and ID cards. The circuit board applied to such a smart IC card includes an insulating layer and a circuit pattern layer disposed on the insulating layer.

At this time, the circuit pattern layer includes a bonding portion and a contact portion. The bonding portion refers to an upper surface of the circuit pattern layer. For example, the bonding portion refers to a surface of the circuit pattern layer that is connected to the IC chip. In addition, the contact portion refers to a lower surface or a second surface of the circuit pattern layer. For example, the contact portion refers to a surface of the circuit pattern layer that is in contact with an external device (e.g., a card reader).

In addition, a surface treatment layer is disposed on each of the bonding portion and the contact portion of the circuit pattern layer. The surface treatment layer is formed to impart a certain level or higher of wire bonding properties, corrosion resistance, oxidation resistance, wear resistance, and hardness to the bonding portion and the contact portion of the circuit pattern layer.

However, a conventional circuit board as described above must necessarily form a surface treatment layer on the circuit pattern layer, and thus, a process of manufacturing the circuit board is complicated and a manufacturing cost increases. In addition, the conventional circuit board has a problem in that an overall thickness increases by a thickness of the surface treatment layer.

(Patent Document 1) KR 10-2002-0011361 A

### [Disclosure]

### [Technical Problem]

The embodiment provides a circuit board having a novel structure and a chip package including the same.

In addition, the embodiment provides a circuit board from which a surface treatment layer on at least one of a bonding portion and a contact portion of a circuit pattern layer is removed, and a chip package including the same.

In addition, the embodiment provides a circuit board capable of being slimmed down by drastically reducing an overall thickness, and a chip package including the same.

In addition, the embodiment provides a circuit board capable of removing an insulating layer included in a conventional circuit board, and a chip package including the same.

In addition, the embodiment provides a circuit board capable of improving adhesion between an insulating layer and a circuit pattern layer, and a chip package including the same.

In addition, the embodiment provides a circuit board including a circuit pattern layers with different surface roughness of upper, side, and lower surfaces, and a chip package including the same.

### [Technical Solution]

A circuit board according to an embodiment comprises a first metal layer; and a second metal layer disposed on the first metal layer, wherein the first metal layer includes an oxide layer formed by oxidizing a region at a predetermined depth from a lower surface of the first metal layer, the first metal layer and the second metal layer include a plurality of electrode patterns disposed on the oxide layer and spaced apart from each other, and the oxide layer insulates between the plurality of electrode patterns.

In addition, the circuit board further comprises an organic layer disposed under a lower surface of the oxide layer, and the organic layer functions as an insulating layer that insulates between the plurality of electrode patterns together with the oxide layer.

In addition, the second metal layer is an alloy layer containing nickel (Ni) and iron (Fe), and the first metal layer is a metal layer plated or deposited under a lower surface of the second metal layer.

In addition, the second metal layer includes a first metal having a content in a range of 60 wt% to 80 wt%, a second metal having a content in a range of 10 wt% to 22 wt%, a third metal having a content in a range of 3 wt% to 20 wt%, and a fourth metal having a content in a range of 3 wt% to 10 wt%, wherein the first metal includes one of nickel (Ni) and iron (Fe), the second metal includes chromium (Cr), the third metal includes one of nickel (Ni) and iron (Fe), which is different from the first metal, and the fourth metal includes one of silver (Ag), silicon (Si), and a silver (Ag)-silicon (Si) alloy.

In addition, the first metal layer includes copper (Cu).

In addition, a total thickness of the first metal layer including the oxide layer is in a range of 7 um to 15 um, a thickness of the oxide layer in the first metal layer is in a range of 3 um to 5 um, and a thickness of the second metal layer is in a range of 100 um to 200 um.

In addition, a total thickness of the first metal layer including the oxide layer is in a range of 2 um to 10 um, a thickness of the oxide layer in the first metal layer is in a range of 0.2 um to 5 um, and a thickness of the second metal layer is in a range of 20 um to 50 um.

In addition, the oxide layer includes at least one opening, the first metal layer includes a first region vertically overlapping the opening, and a second region excluding the first region, wherein a recess is formed in the first region of the first metal layer and connected to the opening, and a thickness of the first region of the first metal layer is smaller than a thickness of the second region of the first metal layer.

In addition, the second metal layer includes a third region vertically overlapping the opening and the recess, and a fourth region excluding the third region, the recess penetrates upper and lower surfaces of the first metal layer, and a lower surface of the third region of the second metal layer is exposed without contacting the first metal layer and the oxide layer.

In addition, the circuit board further comprises a first adhesive layer disposed between the oxide layer and the organic layer, the organic layer includes at least one through hole, and the first adhesive layer includes an open region vertically overlapping the through hole.

In addition, a lower surface of the oxide layer of the first metal layer has an arithmetic mean roughness (Ra) of 0.5 um to 0.9 um or a 10-point average roughness (Rz) of 1.5 um to 2.5 um.

Meanwhile, a chip package according to an embodiment comprises an insulating layer including at least one through hole; a circuit pattern layer disposed on the insulating layer; an adhesive layer disposed under a lower surface of the insulating layer; an IC chip attached to the adhesive layer; and a connection member connecting a lower surface of the circuit pattern layer vertically overlapping the through hole and the IC chip, and wherein the circuit pattern layer includes: a first metal layer; and a second metal layer disposed on the first metal layer, and the first metal layer includes an oxide layer formed by oxidizing a region at a predetermined depth from a lower surface of the first metal layer and corresponding to the insulating layer, and the second metal layer is an alloy layer including nickel (Ni) and iron (Fe).

In addition, the adhesive layer is disposed under a lower surface of the oxide layer.

In addition, the chip package includes an organic layer disposed under the oxide layer, and the adhesive layer is disposed under a lower surface of the organic layer.

In addition, the chip package includes: a first surface layer including nickel (Ni) disposed under a lower surface of the first metal layer vertically overlapping the through hole; and a second surface layer including gold (Au) disposed under a lower surface of the first surface layer, and one end of the connection member is connected to a terminal of the IC chip, and other end of the connection member is connected to the second surface layer.

### [Advantageous Effects]

The circuit board of the embodiment includes an insulating layer and a circuit pattern layer disposed on the insulating layer. The circuit pattern layer includes a first metal layer and a second metal layer. In addition, the second metal layer is a rolled alloy layer, and the first metal layer is a metal layer formed on one surface of the rolled alloy layer. At this time, an oxide layer is formed by oxidizing a surface of the first metal layer and formed at an interface between the first metal layer and the insulating layer. At this time, the oxide layer has a needle-like structure and can improve an adhesion between the first metal layer and the insulating layer.

Accordingly, the embodiment can solve the reliability problem of the circuit pattern layer including the first metal layer being peeled off from the insulating layer by improving the adhesion between the insulating layer and the first metal layer.

Furthermore, the embodiment can further improve the insulation characteristics of the circuit board by using the oxide layer disposed between the first metal layer and the insulating layer.

Meanwhile, the embodiment allows the second metal layer of the circuit pattern layer to be formed using an alloy including nickel (Ni)-chromium (Cr)-iron (Fe), and at least one metal selected from the group consisting of silver (Ag), silicon (Si), and alloys thereof. Accordingly, the second metal layer in the embodiment can have a certain level or higher of wear resistance, corrosion resistance, oxidation resistance and hardness. Through this, the embodiment can omit or remove a surface treatment layer that must be formed on the contact portion of the circuit pattern layer, thereby simplifying a manufacturing process of the circuit board and reducing a manufacturing cost.

Meanwhile, the first metal layer of the embodiment includes a recess formed in a region that vertically overlaps a through hole of the insulating layer. In addition, the recess can solve electrical reliability problem that occurs due to the oxide layer remaining on a bonding portion of the circuit pattern layer. Accordingly, the embodiment can improve electrical reliability of the circuit board and the chip package, and further improve product reliability.

In addition, the recess of the first metal layer can have a structure that penetrates the first metal layer. Accordingly, a lower surface of the second metal layer vertically overlapping the recess of the first metal layer can function as a bonding portion of the circuit pattern layer. At this time, the second metal layer of the circuit pattern layer in the embodiment can have a wire bonding property of a certain level or higher. Through this, the embodiment can omit or remove not only a surface treatment layer that must be formed on a contact portion of the circuit pattern layer, but also a surface treatment layer that must be formed on the bonding portion of the circuit pattern layer. Through this, the embodiment can further simplify the manufacturing process of the circuit board accordingly, and further reduce the manufacturing cost.

Furthermore, the embodiment can form an insulating layer using only an oxide layer formed on the lower surface of the first metal layer. That is, the embodiment allows the metal oxide layer to function as an insulating layer while removing the insulating layer of the organic material.

That is, the insulating layer of the circuit board of the embodiment can be formed only by the oxide layer formed on the lower surface of the first metal layer. Accordingly, the embodiment can further reduce a thickness of the circuit board by performing a function of the insulating layer using the oxide layer.

Furthermore, the embodiment can increase a thickness of the second metal layer of the circuit pattern layer by a thickness of the insulating layer of an organic material by removing the insulating layer of the organic material. At this time, the second metal layer is a rolled alloy layer. At this time, when the rolled alloy layer is manufactured to a thickness of 100 um or less, an additional rolling process is required, thereby increasing the manufacturing cost. Accordingly, the embodiment can omit the additional rolling process for reducing the thickness of the rolled alloy layer under a condition of not increasing a product thickness. Through this, the embodiment can simplify the manufacturing process of the circuit board, thereby reducing the manufacturing cost. Furthermore, the embodiment can improve overall bending characteristics of the circuit board by increasing the thickness of the second metal layer.

### [Description of Drawings]

FIG. 1 is a view showing a chip package according to a comparative example.
FIG. 2 is a view showing a circuit board according to the first embodiment, FIG. 3 is a plan view of the circuit board of FIG. 2 viewed from an upper side, and FIG. 4 is a plan view of the circuit board of FIG. 2 viewed from a lower side.
FIG. 5 is a view showing a first modified example of the circuit board of FIG. 2.
FIG. 6 is a view showing a third modified example of the circuit board of FIG. 2.
FIG. 7 is a view showing a fourth modified example of the circuit board of FIG. 2.
FIG. 8 is a view showing a chip package according to a first embodiment.
FIG. 9 is a view showing a circuit board according to a second embodiment.
FIG. 10 is a view showing a modified example of the circuit board of the second embodiment of FIG. 9.
FIG. 11 is a view showing a chip package of a second embodiment.

### [Modes of the Invention]

Hereinafter, exemplary embodiments of the present invention will be described in detail with reference to the accompanying drawings, wherein like reference numerals are used to designate identical or similar elements, and redundant description thereof will be omitted. The suffix "module" and "portion" of the components used in the following description are only given or mixed in consideration of ease of preparation of the description, and there is no meaning or role to be distinguished as it is from one another. Also, in the following description of the embodiments of the present invention, a detailed description of related arts will be omitted when it is determined that the gist of the embodiments disclosed herein may be obscured. Also, the accompanying drawings are included to provide a further understanding of the invention, are incorporated in, and constitute a part of this description, and it should be understood that the invention is intended to cover all modifications, equivalents, or alternatives falling within the spirit and scope of the invention.

Terms including ordinals, such as first, second, etc., may be used to describe various components, but the elements are not limited to these terms. The terms are used only for distinguishing one component from another.

When a component is referred to as being "connected" or "contacted" to another component, it may be directly connected or joined to the other component, but it should be understood that other component may be present therebetween. When a component is referred to as being "directly connected" or "directly contacted" to another component, it should be understood that other component may not be present therebetween.

A singular representation includes plural representations, unless the context clearly implies otherwise.

In the present application, terms such as "including" or "having" are used to specify the presence of features, numbers, steps, operations, components, parts, or combinations thereof described in the description. However, it should be understood that the terms do not preclude the presence or addition of one or more other features, numbers, steps, operations, components, parts, or combinations thereof.

Hereinafter, embodiments of a present invention will be described in detail with reference to attached drawings.

### - Comparative Example -

Before explaining the embodiment, a comparative example compared with the circuit board of the embodiment of the present invention will be described.

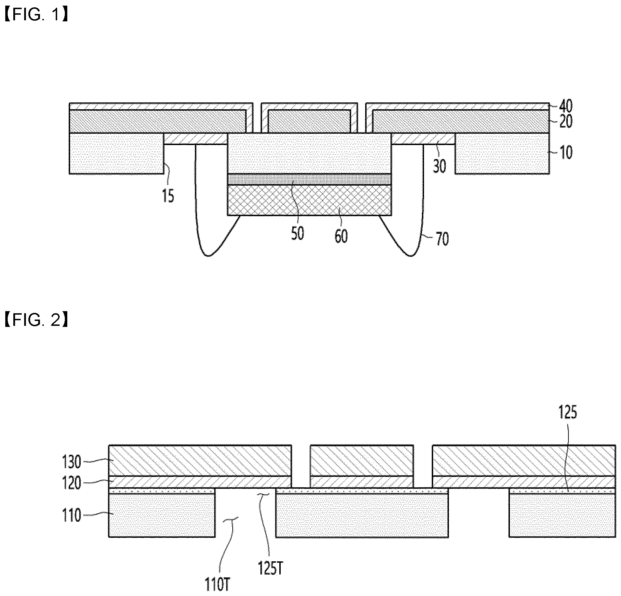

FIG. 1 is a view showing a chip package according to a comparative example.

Referring to FIG. 1, a chip package according to the comparative example includes an insulating layer 10, a circuit pattern layer 20, a first surface treatment layer 30, a second surface treatment layer 40, an adhesive layer 50, an IC chip 60, and a connection member 70.

The chip package of the comparative example includes an insulating layer 10, and a circuit pattern layer 20 is disposed on at least one surface of the insulating layer 10.

At this time, the circuit pattern layer 20 in the comparative example is a copper layer including pure copper.

The insulating layer 10 includes at least one through hole 15. In addition, the circuit pattern layer 20 includes a bonding portion that vertically overlaps the through hole 15. For example, at least a part of the circuit pattern layer 20 vertically overlaps with the through hole 15, and the lower surface of the circuit pattern layer 20 vertically overlapped with the through hole 15 functions as a bonding portion electrically connected to the IC chip 60.

In addition, an upper surface of the circuit pattern layer 20 functions as a contact portion such as a contact portion that contacts an external device (e.g., a card reader).

At this time, different properties are required for the bonding portion and the contact portion of the circuit pattern layer 20.

For example, the bonding portion of the circuit pattern layer 20 requires a certain level of wire bonding property or higher for bonding the connection member 70 electrically connected to the IC chip 60.

In addition, the contact portion of the circuit pattern layer 20 is exposed to an outside of the chip package, and therefore, a certain level of corrosion resistance, oxidation resistance, wear resistance, and hardness or higher is required for continuous connection with an external device.

Accordingly, the circuit board of the comparative example includes a first surface treatment layer 30 formed on the bonding portion of the circuit pattern layer 20, and a second surface treatment layer 40 formed on the contact portion of the circuit pattern layer 20. The first surface treatment layer 30 and the second surface treatment layer 40 each include a nickel metal layer (Ni) and a gold metal layer (Au).

The nickel metal layer acts as a barrier to prevent oxidation of copper (Cu) forming the circuit pattern layer 20, while preventing the copper (Cu) from diffusing into the gold metal layer. In addition, the gold metal layer of the first surface treatment layer 30 is formed on an outermost surface of the bonding portion of the circuit pattern layer 20, thereby providing a wire bonding property of a certain level or higher to the bonding portion. In addition, the gold metal layer of the second surface treatment layer 40 is formed on an outermost surface of the contact portion of the circuit pattern layer 20, thereby providing a certain level of corrosion resistance, oxidation resistance, wear resistance, and hardness to the contact portion.

However, the circuit board of the comparative example as described above must form a first surface treatment layer 30 and a second surface treatment layer 40 on the bonding portion and contact part of the circuit pattern layer 20. As a result, there is a problem that the manufacturing process is complicated and the manufacturing cost is increased.

In addition, the circuit board of the comparative example reduces a thickness of the gold metal layer of the second surface treatment layer 40 for a purpose of reducing the manufacturing cost. However, when the thickness of the gold metal layer is reduced, there is a problem in that the gold metal layer is worn during the long use of the circuit board, thereby damaging the product design.

Meanwhile, in the comparative example, the circuit pattern layer 20 is formed of an aluminum alloy in order to remove at least one of the first and second surface treatment layers described above. However, the aluminum alloy has low hardness property. Accordingly, in order for the contact portion of the circuit pattern layer to have a certain level of corrosion resistance, oxidation resistance, wear resistance, and hardness, a thickness of the aluminum alloy must be 80 µm or more.

In addition, when the thickness of the aluminum alloy exceeds 80 µm, an overall thickness of the circuit board increases accordingly, and a line width or pitch of the circuit pattern layer 20 increases, thereby decreasing the circuit integration.

### - Embodiment -

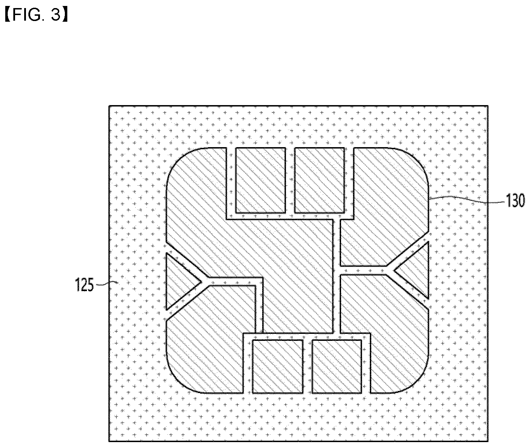

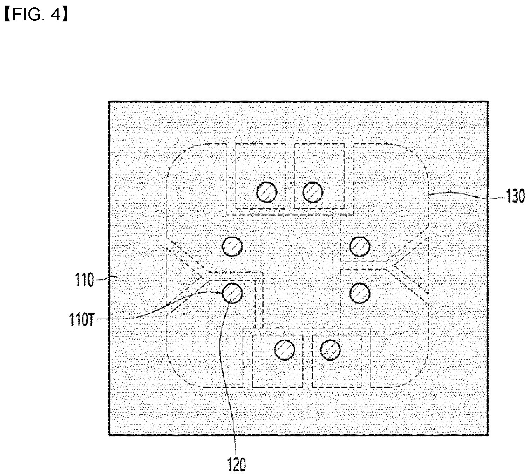

FIG. 2 is a view showing a circuit board according to the first embodiment, FIG. 3 is a plan view of the circuit board of FIG. 2 viewed from an upper side, and FIG. 4 is a plan view of the circuit board of FIG. 2 viewed from a lower side.

Hereinafter, the circuit board of the first embodiment will be described with reference to FIGS. 2 to 4.

Referring to FIGS. 2 to 4, the circuit board of the first embodiment includes an insulating layer 110 and a circuit pattern layer.

Specifically, the circuit pattern layer includes a first metal layer 120 disposed on the insulating layer 110 and a second metal layer 130 disposed on the first metal layer 120. Furthermore, one surface of the first metal layer 120 includes an oxide layer 125 formed using an oxide. For example, the oxide layer 125 of the first metal layer 120 is formed between the first metal layer 120 and the insulating layer 110.

The oxide layer 125 can have a function of improving an adhesion between the circuit pattern layer and the insulating layer 110. In addition, the oxide layer 125 can function as the insulating layer 110. For example, the oxide layer 125 formed at a surface of the first metal layer 120 has non-conductivity. Therefore, the oxide layer 125 can also be said to be an insulator that performs an insulating function together with the insulating layer 110 in the circuit board of the first embodiment.

At this time, although the oxide layer 125 is shown as a separate layer from the first metal layer 120 in the drawing, the oxide layer 125 actually means a part of the first metal layer 120.

Accordingly, the insulating layer of the circuit board of the first embodiment may include a 'first insulating layer' corresponding to the insulating layer 110 and a 'second insulating layer' corresponding to the oxide layer 125 of the first metal layer 120.

The insulating layer 110 includes an insulating material.

The insulating layer 110 has a thickness in a range of 60 um to 120 um, or a thickness in a range of 70 um to 110 um, or a thickness in a range of 80 um to 100 um.

If a thickness of the insulating layer 110 is less than 60 um, the rigidity of the circuit board may be weakened, and thus warpage characteristics of the circuit board may be deteriorated. If the thickness of the insulating layer is less than 60 um, the circuit pattern layer may not be stably formed on the circuit board. For example, if the thickness of the insulating layer 110 is less than 60 um, the processability in a patterning process for forming the circuit pattern layer is deteriorated.

If the thickness of the insulating layer 110 exceeds 120 um, the overall thickness of the circuit board increases, and thus the thickness of the chip package increases.

The insulating layer 110 includes at least one through hole 110T.

The through hole 110T penetrates upper and lower surfaces of the insulating layer 110.

A circuit pattern layer is formed on the insulating layer 110. The circuit pattern layer is formed on an upper surface of the insulating layer 110. However, the embodiment is not limited thereto, and the circuit pattern layer may be formed on a lower surface of the insulating layer 110.

The circuit pattern layer includes a plurality of metal layers.

For example, the circuit pattern layer includes a first metal layer 120 disposed on the upper surface of the insulating layer 110. In addition, the circuit pattern layer includes a second metal layer 130 disposed on an upper surface of the first metal layer 120.

The second metal layer 130 is an alloy layer. In addition, the first metal layer 120 can be said to be a plated or deposited metal layer formed on one surface of the second metal layer 130, which is the alloy layer. The first metal layer 120 is disposed on a lower surface of the second metal layer 130 with a certain thickness to form the oxide layer 125.

That is, the second metal layer 130 is an alloy layer manufactured by a rolling method. Accordingly, a surface roughness of the second metal layer 130 can have a very low value due to the characteristics of the alloy layer manufactured by a rolling method. The first metal layer 120 may be a plating layer formed on one surface of the second metal layer 130 by an electroless plating method or a deposition layer deposited by a sputtering method.

The first metal layer 120 includes copper. However, the embodiment is not limited thereto, and the first metal layer 120 may be formed by plating or depositing a metal layer other than copper on one surface of the second metal layer 130.

The first metal layer 120 has an arithmetic mean roughness (Ra) of an oxide layer 125 in a range of 0.5 um to 0.9 um. In addition, the oxide layer 125 of the first metal layer 120 may have a 10-point average roughness (Rz) in a range of 1.5 um to 2.5 um. At this time, the oxide layer 125 is a part of the first metal layer 120, and accordingly, the arithmetic mean roughness (Ra) and the 10-point average roughness (Rz) of the oxide layer 125 can also be referred to as a surface roughness of a lower surface of the first metal layer 120.

Therefore, the embodiment can improve the adhesion between the circuit pattern layer and the insulating layer 110 by having the oxide layer 125 of the first metal layer 120 have a surface roughness in an above range.

At this time, the first metal layer 120 includes the oxide layer 125 formed on the lower surface that contacts the insulating layer 110. Specifically, the first embodiment includes the oxide layer 125 formed at an interface between the first metal layer 120 and the insulating layer 110. The oxide layer 125 is formed by oxidizing a certain depth region of the lower surface of the first metal layer 120 using an oxide material. The oxide layer 125 has a needle-like structure. In addition, the embodiment can improve the adhesion with the insulating layer 110 by having the needle-like structure of the oxide layer 125. Accordingly, the embodiment can solve the problem of the circuit pattern layer being peeled off from the insulating layer 110.

In addition, the oxide layer 125 of the first metal layer 120 has an insulation characteristic. Therefore, the embodiment can further improve the insulation characteristic between the circuit pattern layer including the first metal layer 120 and the insulating layer 110. Accordingly, the embodiment can improve the electrical reliability of the circuit pattern layer.

The oxide layer 125 includes an opening 125T. For example, the oxide layer 125 is partially formed on a lower surface of the first metal layer 120. For example, the oxide layer 125 includes an opening 125T that vertically overlaps with the through hole 110T of the insulating layer 110 on the lower surface of the first metal layer 120.

Accordingly, at least a portion of the first metal layer 120 vertically overlaps with the through hole 110T of the insulating layer 110 and the opening 125T of the oxide layer 125. In addition, in the first embodiment, at least a portion of the oxide layer 125 does not vertically overlap with the first metal layer 120 and the second metal layer 130. For example, the first metal layer 120 and the second metal layer 130 include a plurality of electrode patterns (not shown) that are horizontally spaced apart from each other on the insulating layer 110. And, the oxide layer 125 of the first embodiment is disposed on the upper surface of the insulating layer 110 between the plurality of electrode patterns. Through this, the first embodiment can further improve the insulation characteristics between the plurality of electrode patterns by using the oxide layer 125.

In the first embodiment, a thickness of the first metal layer 120 satisfies a range of 2 um to 10 um. Preferably, a thickness of the first metal layer 120 satisfies a range of 2.5 um to 9.5 um. More preferably, a thickness of the first metal layer 120 satisfies a range of 3 um to 9 um. At this time, a thickness of the first metal layer 120 means a total thickness of the first metal layer 120 including a thickness of the oxide layer 125.

If the thickness of the first metal layer 120 is smaller than 2 um, the oxide layer 125 of the first metal layer 120 does not have a target level of surface roughness, and thus the adhesion between the insulating layers 110 may be deteriorated. In addition, if the thickness of the first metal layer 120 is smaller than 2um, the oxide layer 125 may not have a target thickness. In addition, if the oxide layer 125 does not have the target thickness, the adhesion between the first metal layer 120 and the insulating layer 110 may be deteriorated, or the insulation characteristic of the circuit board may be deteriorated.

In addition, if the thickness of the first metal layer 120 exceeds 10um, the thickness of the circuit pattern layer and the thickness of the circuit board may increase corresponding to the thickness of the first metal layer 120. Accordingly, it may be difficult to slim down the circuit board and the chip package.

A thickness of the oxide layer 125 in the first metal layer 120 satisfies a range of 0.2um to 5um. Preferably, a thickness of the oxide layer 125 satisfies a range of 0.22um to 4.8um. More preferably, a thickness of the oxide layer 125 satisfies a range of 0.25 µm to 4.5 µm.

If the thickness of the oxide layer 125 in the first metal layer 120 is smaller than 0.2 µm, the insulation characteristic between the circuit pattern layer provided by the oxide layer 125 and the insulating layer 110 may be deteriorated. In addition, if the thickness of the oxide layer 125 exceeds 5 µm, the strength of the oxide layer 125 may deteriorate, the strength of the oxide layer 125 is reduced and a problem of breaking the oxide layer 125 may occur. Furthermore, if the strength of the oxide layer 125 deteriorates, the adhesion between the insulating layer 110 and the first metal layer 120 deteriorates, and thus, a problem of the first metal layer 120 being peeled off from the insulating layer 110 may occur.

The second metal layer 130 is disposed on the first metal layer 120. The second metal layer 130 is an alloy layer. For example, the second metal layer 130 is formed of an alloy containing nickel (Ni) or iron (Fe) as a main component. For example, the second metal layer 130 may be an alloy layer formed by a rolling method.

The second metal layer 130 has a thickness in a range of 20 um to 50 um. For example, the second metal layer 130 has a thickness in a range of 25 um to 45 um. For example, the second metal layer 130 has a thickness in a range of 30 um to 40 um. If the thickness of the second metal layer 130 is smaller than 20 um, a resistance value of the second metal layer 130 may increase, and thus, signal loss may increase. For example, if the thickness of the second metal layer 130 is smaller than 20 um, the signal transmission characteristics of the circuit board may deteriorate. If the thickness of the second metal layer 130 exceeds 50um, the overall thickness of the circuit board may increase.

At this time, the embodiment allows the surface treatment layer formed on the contact portion of the second metal layer 130 to be omitted or removed while the thickness of the second metal layer 130 is less than or equal to 50 µm. This can be achieved by the characteristics of the alloy forming the second metal layer 130 described below.

The circuit pattern layer including the first metal layer 120 and the second metal layer 130 includes an upper surface and a lower surface. The upper surface of the circuit pattern layer means an upper surface of the second metal layer 130. In addition, the lower surface of the circuit pattern layer means a lower surface of the first metal layer 120.

Specifically, the contact portion of the circuit pattern layer means an upper surface of the second metal layer 130. In addition, the contact portion of the circuit pattern layer means a region that is arranged at an outermost part of the circuit board and the chip package. For example, the contact portion of the circuit pattern layer means a region that is exposed to an outside of the circuit board and the chip package.

In addition, the bonding portion of the circuit pattern layer means a region that is connected to the IC chip 170 in the chip package. For example, the bonding portion of the circuit pattern layer means a region that vertically overlaps with the through hole 110T of the insulating layer 110. At this time, the oxide layer 125 of the first metal layer 120 is partially formed on the lower surface of the first metal layer 120. For example, the oxide layer 125 is formed on a remaining region of the lower surface of the first metal layer 120 excluding a region that vertically overlaps with the through hole 110T. Accordingly, the oxide layer 125 includes an opening 125T that vertically overlaps with the through hole 110T of the insulating layer 110. In addition, a region of the lower surface of the first metal layer 120 that vertically overlaps with the through hole 110T of the insulating layer 110 and the opening 125T of the oxide layer 125 functions as the bonding portion.

At this time, the second metal layer 130 is required to have a certain level or higher of corrosion resistance, oxidation resistance, wear resistance, and hardness. For example, the contact portion of the circuit pattern layer corresponding to the upper surface of the second metal layer 130 is required to have a certain level or higher of corrosion resistance, oxidation resistance, wear resistance, and hardness.

Accordingly, in the comparative example, a second surface treatment layer 40 is formed on the contact portion of the circuit pattern layer.

In contrast, in the embodiment, the second metal layer 130 is formed using one of first and second alloys having a certain level or higher of corrosion resistance, oxidation resistance, wear resistance, hardness, and wire bonding properties. Through this, the embodiment allows a surface treatment layer formed on the contact portion of the second metal layer 130 to be omitted or removed.

That is, the embodiment allows the second metal layer 130 to have a predetermined level or more of corrosion resistance, oxidation resistance, abrasion resistance, hardness, and wire bonding properties without the surface treatment layer through a change in the content of the metals in an alloy forming the second metal layer 130. This is achieved by the types of metals constituting the second metal layer 130 and their content, which will be described below.

Hereinafter, a composition ratio of metals in the alloy forming the second metal layer 130 will be described.

At this time, the second metal layer 130 is formed using one of a first alloy and a second alloy. The first alloy above has nickel (Ni) as a main component, and the second alloy has iron (Fe) as a main component.

### - First alloy -

The second metal layer 130 can be formed of a first alloy having nickel (Ni) as a main component.

The first alloy has a certain level or higher of corrosion resistance, oxidation resistance, wear resistance, hardness, and wire bonding properties.

That is, the first alloy forming the second metal layer 130 has nickel (Ni) as a main component. For example, a content of nickel (Ni) in the first alloy forming the second metal layer 130 satisfies a range of 60 wt% to 80 wt%. For example, the content of nickel (Ni) in the first alloy is 65 wt% to 78 wt% or 70 wt% to 75 wt%.

If the content of nickel (Ni) in the first alloy is less than 60 wt%, the corrosion resistance, oxidation resistance, wear resistance, hardness, and wire bonding properties of the second metal layer 130 decrease. Accordingly, a surface treatment layer must be formed on the contact portion of the second metal layer 130, and there are problems in that the manufacturing process is complicated, the thickness of the circuit board is increased, and the manufacturing cost is increased.

Specifically, if the content of nickel (Ni) in the first alloy is less than 60 wt%, a surface roughness change rate (%) of the second metal layer 130 exceeds 10%. The surface roughness change rate (%) is related to the corrosion resistance, oxidation resistance, and wear resistance of the second metal layer 130.

Accordingly, the content of nickel (Ni) in the first alloy forming the second metal layer 130 is in the range of 60 wt% to 80 wt%, whereby the surface roughness change rate (%) is 10% or less, preferably 8% or less, and more preferably 5% or less.

In addition, when the content of nickel (Ni) in the first alloy exceeds 80 wt%, an etching rate (µm/min) in a process of forming the second metal layer 130 using the first alloy decreases. That is, if the content of nickel (Ni) in the first alloy exceeds 80 wt%, the hardness of the first alloy is too high, so that an etching rate (µm/min) within a certain range is not achieved in the process of forming the second metal layer 130. In addition, if the content of nickel (Ni) in the first alloy exceeds 80 wt%, a problem occurs in which nickel ions are eluted to the surface of the second metal layer 130 formed with the first alloy.

Meanwhile, the first alloy forming the second metal layer 130 includes chromium (Cr). The content of chromium (Cr) in the first alloy satisfies a range of 10 wt% to 22 wt%. For example, the content of chromium (Cr) in the first alloy satisfies a range of 11 wt% to 21 wt%, or 12 wt% to 18 wt%.

If the content of chromium (Cr) in the first alloy is less than 10 wt%, an amount of nickel eluted to the surface of the second metal layer 130 formed with the first alloy increases.

At this time, if the content of chromium (Cr) in the first alloy is less than 10 wt%, an effect of preventing nickel (Ni) from being eluted by the chromium (Cr) is reduced, and thus, a product reliability problem occurs due to nickel ions being eluted to an outside. Accordingly, the first alloy forming the second metal layer 130 in the embodiment includes chromium (Cr) in a content of 10 wt% or more.

Meanwhile, if the content of chromium (Cr) in the first alloy exceeds 22 wt%, the hardness of the second metal layer 130 increases, and thus, the etching rate (um/min) of the second metal layer 130 decreases. In addition, if the content of chromium (Cr) in the second metal layer 130 exceeds 22 wt%, the wire bonding property of the second metal layer 130 deteriorate.

In addition, when the content of chromium (Cr) in the first alloy is less than 10 wt% or more than 22 wt%, contents of other metals (e.g., nickel or iron) decreases or increases by a corresponding content, and as a result, there is a problem because the content of the other metals does not satisfy an optimum range described herein.

Meanwhile, the first alloy forming the second metal layer 130 includes iron (Fe). The content of iron (Fe) in the first alloy satisfies a range of 3 wt% to 20 wt%. The content of iron (Fe) in the first alloy may satisfy a range of 5 wt% to 15 wt%, or 7 wt% to 11 wt%. The iron (Fe) in the first embodiment functions to improve the rollability (or ductility) of the first alloy.

At this time, if the content of iron (Fe) in the first alloy is less than 3 wt%, the rollability of the first alloy is reduced, and accordingly, it is difficult to manufacture the thickness of the first alloy and further the thickness of the second metal layer 130 to 50 um or less.

In addition, if the content of iron (Fe) in the first alloy exceeds 20 wt%, the content of nickel (Ni) or iron (Fe) decreases accordingly, and accordingly, the amount of nickel elution increases or the surface roughness change rate (%) increases.

Meanwhile, the first alloy forming the second metal layer 130 includes one metal among silver (Ag), silicon (Si), and a silver (Ag)-silicon (Si) alloy. The silver (Ag), silicon (Si), and silver (Ag)-silicon (Si) can enable the first alloy to have a wire bonding property of a certain level or higher.

Accordingly, the first alloy may be any one of a nickel (Ni)-chromium (Cr)-iron (Fe)-silver (Ag) alloy, a nickel (Ni)-chromium (Cr)-iron (Fe)-silver (Ag)-silver (Si) alloy, and a nickel (Ni)-chromium (Cr)-iron (Fe)-silver (Ag)-silver (Si) alloy.

In the first alloy, any one of silver (Ag), silicon (Si), and silver (Ag)-silver (Si) alloy has a content in a range of 3 wt% to 10 wt%.

If the content of any one of silver (Ag), silicon (Si), and silver (Ag)-silver (Si) alloy in the first alloy is less than 3 wt%, the wire bonding property of the second metal layer 130 is less than 4 gf.

If the content of any one of silver (Ag), silicon (Si), and silver (Ag)-silicon (Si) alloy exceeds 10 wt% in the first alloy forming the second metal layer 130, the content of nickel (Ni) or chromium (Cr) or iron (Fe) decreases accordingly, and thus a problem occurs in at least one of the resistance (Ω), etching rate (um/min), surface roughness change rate, and nickel elution amount of the circuit pattern layer.

Meanwhile, the first alloy forming the second metal layer 130 includes at least one additive.

For example, the first alloy forming the second metal layer 130 includes at least one additive selected from manganese (Mn), tin (Sn), zinc (Zn), and an alloy including at least two of these. For example, the additive selected from manganese (Mn), tin (Sn), zinc (Zn), and an alloy including at least two of these are added to refine a structure of the alloy constituting the second metal layer 130 to achieve solid solution strengthening.

Specifically, the content of the additive selected from manganese (Mn), tin (Sn), zinc (Zn), and an alloy including at least two of these satisfies a range of 1 wt% to 5 wt%.

That is, if the content of the additive selected from manganese (Mn), tin (Sn), zinc (Zn), and an alloy including at least two of these is less than 1 wt%, the solid solution strengthening effect is insignificant, and thus the wear resistance, oxidation resistance, and corrosion resistance of the second metal layer 130 deteriorate.

In addition, if the content of the additive selected from manganese (Mn), tin (Sn), zinc (Zn), and an alloy including at least two of these exceeds 5 wt%, the resistance property of the second metal layer 130 increase, and thus the signal loss increases.

In addition, if the content of the additive selected from manganese (Mn), tin (Sn), zinc (Zn), and an alloy including at least two of these exceeds 5 wt%, the hardness of the second metal layer 130 increases, and thus the etching rate (um/min) decreases.

### - Second alloy -

Meanwhile, the second metal layer 130 may be formed of a second alloy having iron (Fe) as a main component.

At this time, the second alloy includes metals constituting the first alloy. However, the content of each metal in the second alloy is different from the content of each metal in the first alloy. For example, the first alloy contains nickel as a main component, and the second alloy contains iron as a main component. Accordingly, the nickel (Ni), iron (Fe), and chromium (Cr) contents in the second alloy are different from the nickel (Ni), iron (Fe), and chromium (Cr) contents in the first alloy.

That is, the second alloy forming the second metal layer 130 contains iron (Fe) as a main component. For example, the content of iron (Fe) in the second alloy satisfies a range of 60 wt% to 80 wt%, or 61 wt% to 78 wt%, or 63 wt% to 75 wt%. The optimal range of the content of iron (Fe) in the second alloy is 63 wt% to 75 wt%.

If the content of iron (Fe) in the second alloy is less than 60 wt%, the rollability of the second alloy deteriorates, and accordingly, the thickness of the second alloy increases, and further, the thickness of the second metal layer 130 increases. If the content of iron (Fe) in the second alloy exceeds 80 wt%, the wear resistance, corrosion resistance, and oxidation resistance of the second metal layer 130 formed of the second alloy decrease. In addition, if the content of iron (Fe) in the second alloy exceeds 80 wt%, the resistance (Ω) of the second metal layer 130 formed of the second alloy increases, and accordingly, the signal transmission loss increases. In addition, if the content of iron (Fe) in the second alloy is less than 60 wt% or exceeds 80 wt%, contents of other metals (for example, nickel or chromium) decreases or increases by the corresponding content, and thus, a problem occurs in that the content of the other metal does not satisfy the optimal range described herein.

Meanwhile, the content of chromium (Cr) in the second alloy satisfies a range of 10 wt% to 22 wt%, or 13 wt% to 21 wt%, or 15 wt% to 20 wt%. That is, the optimal range of the content of chromium (Cr) in the second alloy is 15 wt% to 20 wt%.

If the content of chromium (Cr) in the second alloy is less than 10 wt%, the amount of nickel elution to the surface of the second alloy increases. In addition, if the content of chromium (Cr) in the second alloy is less than 10 wt%, the hardness of the second metal layer 130 formed of the second alloy decreases. In addition, if the content of chromium (Cr) in the second alloy exceeds 22 wt%, the wire bonding property deteriorates.

Meanwhile, the content of nickel (Ni) in the second alloy satisfies the range of 3 wt% to 20 wt%, or 5 wt% to 18 wt%, or 7 wt% to 15 wt%. That is, an optimal range of the content of nickel (Ni) in the second alloy is 7 wt% to 15 wt%.

If the content of nickel (Ni) in the second alloy is less than 3 wt%, the surface roughness change rate (%) of the second metal layer 130 exceeds 10%. In addition, if the content of nickel (Ni) in the second alloy exceeds 20 wt%, the etching rate (um/min) in the etching process for forming the second metal layer 130 using the second alloy is reduced.

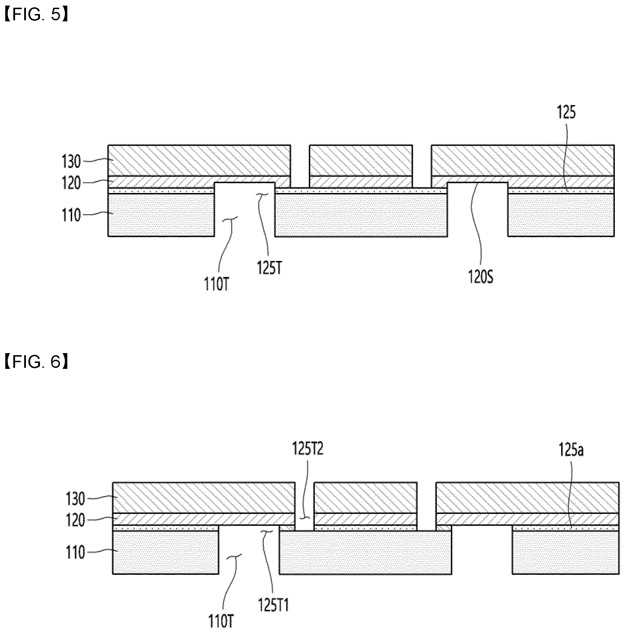

FIG. 5 is a view showing a first modified example of the circuit board of FIG. 2.

Referring to FIG. 5, the circuit board of the first modified example includes an insulating layer 110 and a circuit pattern layer. The circuit pattern layer includes a first metal layer 120 disposed on an insulating layer 110 and including an oxide layer 125. In addition, the circuit pattern layer includes a second metal layer 130 disposed on the first metal layer 120.

At this time, a lower surface of the first metal layer 120 of the circuit board of FIG. 2 has the same height in an entire region. For example, a lower surface of the first metal layer 120 of the circuit board of FIG. 2 does not have a step.

Unlike this, the circuit board of the first modified example has a lower surface of the first metal layer 120 having a step. For example, the lower surface of the first metal layer 120 includes a first region vertically overlapping with a through hole 110T of the insulating layer 110 and a second region excluding the first region. In addition, a height of the first region of the lower surface of the first metal layer 120 is different from a height of the second region of the lower surface of the first metal layer 120. Preferably, a height of the first region of the lower surface of the first metal layer 120 is positioned higher than a height of the second region of the lower surface of the first metal layer 120.

For example, the thickness of the first region of the first metal layer 120 is smaller than the thickness of the second region. Specifically, the lower surface of the first metal layer 120 includes a recess 120S that vertically overlaps the through hole 110T of the insulating layer 110 and the opening 125T of the oxide layer 125. The recess 120S is formed by removing a part of the lower surface of the first metal layer 120 in a process of forming the through hole 110T of the insulating layer 110 and the opening 125T of the oxide layer 125. At this time, when the recess 120S does not exist, the oxide layer 125 may remain in at least a part of the region of the lower surface of the first metal layer 120 that vertically overlaps the through hole 110T. In addition, if the oxide layer 125 remains in a region overlapping the through hole 110T, the electrical reliability between the IC chip 170 and the circuit pattern layer may be deteriorated. Accordingly, in the first modified example, a recess 120S is formed on the lower surface of the first metal layer 120 in a process of forming the through hole 110T and the opening 125T. Through this, the embodiment improves the electrical reliability between the bonding portion of the circuit pattern layer and the IC chip 170.

At this time, in the first modified example, the recess 120S is described as being formed by removing a part of the first metal layer 120, but it is not limited thereto.

For example, a recess 120S in a second modified example has a through hole type that penetrates the upper surface and the lower surface of the first metal layer 120. Accordingly, the lower surface of the second metal layer 130 in a region vertically overlapping the through hole 110T of the insulating layer 110, the opening 125T of the oxide layer 125, and the recess 120S of the first metal layer 120 is exposed. In addition, the exposed lower surface of the second metal layer 130 functions as a bonding portion.

At this time, in the first embodiment and the first modified example, the lower surface of the first metal layer 120 functions as a bonding portion of the circuit pattern layer. Accordingly, in the first embodiment and the first modified example, a surface treatment layer must be formed on the lower surface of the bonding portion for wire bonding with the IC chip 170.

Unlike this, as in the second modified example, when the recess 120S penetrates the first metal layer 120, the lower surface of the second metal layer 130 functions as a bonding portion of the circuit pattern layer. In addition, the second metal layer 130 is formed of a first alloy or a second alloy having a wire bonding property of a certain level or higher. Accordingly, the circuit board of the second modified example can also remove the surface treatment layer disposed on the bonding portion of the circuit pattern layer.

FIG. 6 is a view showing a third modified example of the circuit board of FIG. 2.

Referring to FIG. 6, the circuit board of the third modified example includes an insulating layer 110, a first metal layer 120, and a second metal layer 130. At this time, the insulating layer 110, the first metal layer 120, and the second metal layer 130 may have substantially the same structure as in the first embodiment. Accordingly, a detailed description thereof will be omitted.

At this time, the oxide layer 125 in the first embodiment included only an opening 125T formed in a region vertically overlapping with a through hole 110T of the insulating layer 110.

In contrast, the oxide layer 125a of the circuit board of the third modified example includes a first opening 125T1 and a second opening 125T2.

The first opening 125T1 of the oxide layer 125a is formed in a region that vertically overlaps the through hole 110T. The first opening 125T1 corresponds to the opening 125T of the previous embodiment.

In addition, the second opening 125T2 of the oxide layer 125a is formed in a region between the plurality of electrode patterns of the circuit pattern layer in the oxide layer 125a. For example, in the third modified example, in the process of forming the plurality of electrode patterns of the circuit pattern layer, the oxide layer 125a is removed together with the first metal layer 120 and the second metal layer 130. Accordingly, the oxide layer 125a further includes a second opening 125T2 between the plurality of electrode patterns.

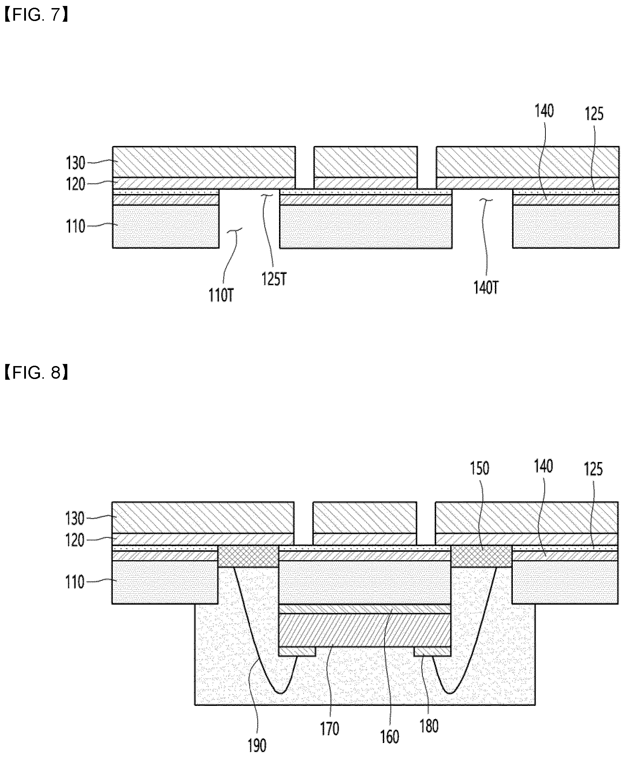

FIG. 7 is a view showing a fourth modified example of the circuit board of FIG. 2.

Referring to FIG. 7, the circuit board includes an insulating layer 110, a first metal layer 120, and a second metal layer 130 corresponding to the circuit board of FIG. 2. In addition, an oxide layer 125 is formed on the lower surface of the first metal layer 120.

At this time, the circuit board of the fourth modified example includes a first adhesive layer 140 disposed between the oxide layer 125 of the first metal layer 120 and the insulating layer 110.

The first adhesive layer 140 may be a bonding sheet. The first adhesive layer 140 may be an epoxy-based bonding sheet, but is not limited thereto.

The first adhesive layer 140 is disposed between the oxide layer 125 of the first metal layer 120 and the insulating layer 110. As a result, in the fourth modified example, the adhesion between the circuit pattern layer and the insulating layer 110 can be further improved.

The first adhesive layer 140 may have a same plane area as the insulating layer 110. For example, the first adhesive layer 140 may include an open region 140T corresponding to the through hole 110T of the insulating layer 110.

In the fourth modified example, the adhesion between the insulating layer 110 and the circuit pattern layer can be further improved by arranging the first adhesive layer 140 between the oxide layer 125 of the first metal layer 120 and the insulating layer 110. Accordingly, the embodiment can prevent the circuit pattern layer from being peeled off from the insulating layer 110, and thereby further improve the electrical reliability of the circuit pattern layer.

FIG. 8 is a view showing a chip package according to the first embodiment. At this time, the chip package of the first embodiment may include the circuit board of FIG. 7. However, the embodiment is not limited thereto. For example, the chip package of the first embodiment may include a circuit board of another embodiment other than the circuit board of FIG. 7.

The chip package of the first embodiment includes a surface treatment layer 150. The surface treatment layer 150 is formed in a region that vertically overlaps the through hole 110T of the insulating layer 110 and the opening 125T of the oxide layer 125 and formed on the lower surface of the circuit pattern layer.

The surface treatment layer 150 is formed on the bonding portion of the circuit pattern layer. Preferably, the surface treatment layer 150 is formed on the lower surface of the first metal layer 120 that vertically overlaps the through hole 110T and the opening 125T. In this case, when the recess 120S passes through the first metal layer 120, a lower surface of the second metal layer 130 rather than a lower surface of the first metal layer 120 may function as a bonding part of the circuit pattern layer. Accordingly, the surface treatment layer 150 may also be omitted or removed.

Meanwhile, when the surface treatment layer 150 is formed on the bonding portion, the surface treatment layer 150 includes a metal having a certain level or higher of wire bonding property. To this end, the surface treatment layer 150 includes a plurality of surface layers. For example, the surface treatment layer 150 includes a first surface layer including nickel. In addition, the surface treatment layer 150 includes a second surface treatment layer that is disposed under the first surface layer and includes gold. The first surface layer may have a thickness in a range of 2 µm to 3 µm. If the thickness of the first surface layer is less than 2 µm, the bonding reliability between the first metal layer 120 and the second surface layer may deteriorate. In addition, if the thickness of the first surface layer exceeds 3 µm, the manufacturing cost may increase. Meanwhile, the second surface layer may have a thickness in a range of 0.2 µm to 0.5 µm. If the thickness of the second surface layer is less than 0.2 µm, the wire bonding property may deteriorate. If the thickness of the second surface layer exceeds 0.5 µm, the manufacturing cost may increase.

The chip package includes a second adhesive layer 160 disposed on the lower surface of the insulating layer 110 of the circuit board. The second adhesive layer 160 is for bonding an IC chip 170 to the lower surface of the insulating layer 110. The second adhesive layer 160 may be an epoxy, a thermosetting adhesive, and an ultraviolet adhesive, but is not limited thereto.

An IC chip 170 is attached to the second adhesive layer 160. The IC chip 170 includes a terminal 180. In addition, the terminal 180 of the IC chip 170 is electrically connected to a bonding portion of a circuit pattern layer (specifically, a surface treatment layer 150) through a connection member 190 such as a wire. Specifically, one end of the connection member 190 is connected to the terminal 180 of the IC chip 170 and other end of the connection member 190 is connected to the lower surface of the surface treatment layer 150.

Meanwhile, the chip package includes a molding layer. The molding layer may be EMC (Epoxy Molding Compound), but is not limited thereto. The molding layer is arranged on the lower surface of the insulating layer 110. The molding layer molds the IC chip 170 and the connection member 190.

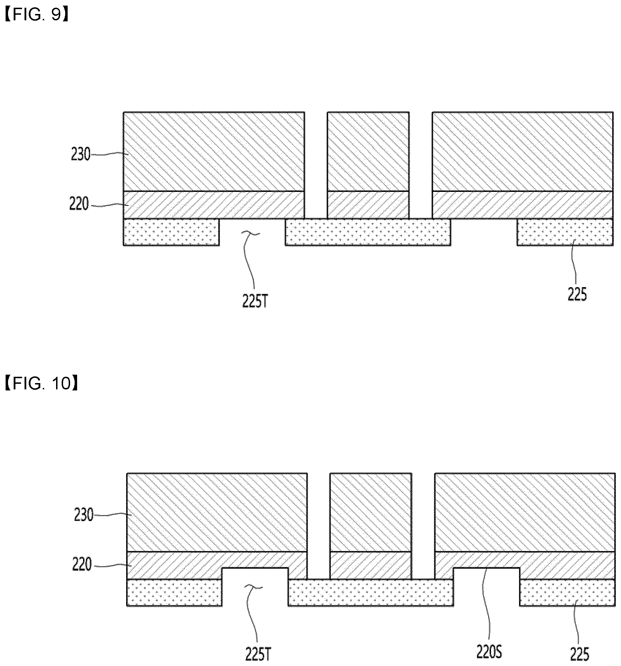

FIG. 9 is a view showing a circuit board according to the second embodiment.

Hereinafter, the circuit board according to the second embodiment will be described.

At this time, the circuit board of the first embodiment included an insulating layer 110. The insulating layer 110 is an insulating layer of an organic material.

Differently, the circuit board of the second embodiment removes the insulating layer 110 included in the circuit board of the first embodiment.

Referring to FIG. 9, the circuit board includes a first metal layer 220 and a second metal layer 230 disposed on the first metal layer 220.

At this time, the first metal layer 220 of the second embodiment corresponds to the first metal layer 120 of the first embodiment, and further, the second metal layer 230 of the second embodiment corresponds to the second metal layer 130 of the first embodiment.

However, the circuit board of the second embodiment has a structure in which the insulating layer 110 is removed from the circuit board of the first embodiment. Accordingly, the first metal layer 220 and the second metal layer 230 of the circuit board of the second embodiment have different thicknesses from the first metal layer and the second metal layer of the first embodiment.

Specifically, the insulating layer of the circuit board of the second embodiment includes only an oxide layer 225 formed by oxidizing a portion of the first metal layer 220. That is, in the second embodiment, the oxide layer 225 is made to perform the function of the insulating layer 110 of the circuit board of the first embodiment.

That is, the insulating layer of the circuit board of the second embodiment is an oxide layer 225 formed by oxidizing a part of the first metal layer 220. In addition, the second embodiment performs the function of the insulating layer by using the oxide layer 225, thereby further reducing the thickness of the product compared to the circuit board of the first embodiment.

Furthermore, when the circuit board of the second embodiment has the same thickness as the circuit board of the first embodiment, the thickness of the second metal layer 230 can be increased compared to the first embodiment. At this time, the second metal layer 230 is a rolled alloy. At this time, when the rolled alloy is manufactured to a thickness of 100 um or less, an additional rolling process is required, which increases the manufacturing cost. In contrast, the circuit board of the second embodiment can omit the additional rolling process, thereby simplifying the manufacturing process and reducing the manufacturing cost. Furthermore, the circuit board of the second embodiment can increase the thickness of the second metal layer while maintaining the same thickness as the first embodiment, thereby improving the overall bending characteristics of the circuit board.

The first metal layer 220 has a thickness in a range of 7 um to 15 um. If the first metal layer 220 is smaller than 7 um, it is difficult to form an oxide layer 225 having a certain thickness or more on the lower surface of the first metal layer 220, thereby deteriorating the insulation characteristics of the circuit board. In addition, if the thickness of the first metal layer 220 exceeds 5 um, the overall thickness of the circuit board increases.

The oxide layer 225 in the first metal layer 220 satisfies a thickness in a range of 3 um to 5 um. If the thickness of the oxide layer 225 in the first metal layer 220 is 3 um or less, the insulation characteristics deteriorate and the electrical reliability of the circuit board deteriorates. In addition, if the thickness of the oxide layer 225 exceeds 5 um, a breakage problem may occur due to the decrease in the strength of the oxide layer 225.

The oxide layer 225 includes an opening 225T. The opening 225T is formed corresponding to a region that functions as a bonding portion on the lower surface of the first metal layer 220. The opening 225T is formed by removing a part of the oxide layer 225 formed on the lower surface of the first metal layer 220.

The second metal layer 230 has a thickness in a range of 100 um to 200 um. If the thickness of the second metal layer 230 is less than 100 um, the warpage characteristics of the circuit board deteriorate. In addition, if the thickness of the second metal layer 230 is less than 100 um, an additional process is required in a process of manufacturing the second metal layer 230 by rolling. If the thickness of the second metal layer 230 exceeds 200 um, the overall thickness of the circuit board increases.

FIG. 10 is a view showing a modified example of the circuit board of the second embodiment of FIG. 9.

Referring to FIG. 10, the circuit board of the modified example of the second embodiment includes a recess 220S formed in a region that vertically overlaps with the opening 225T of the oxide layer 225 among the lower surfaces of the first metal layer 220.

The recess 220S has a shape that is concaved from the lower surface of the first metal layer 220 toward the upper surface.

The recess 220S is formed to correspond to the opening 225T of the oxide layer 225.

In addition, the recess 220S has the function of completely removing the oxide layer 225 remaining on the lower surface of the first metal layer 220 that functions as the bonding portion.

At this time, the recess 220S in another modified example may have a structure that penetrates the first metal layer 220.

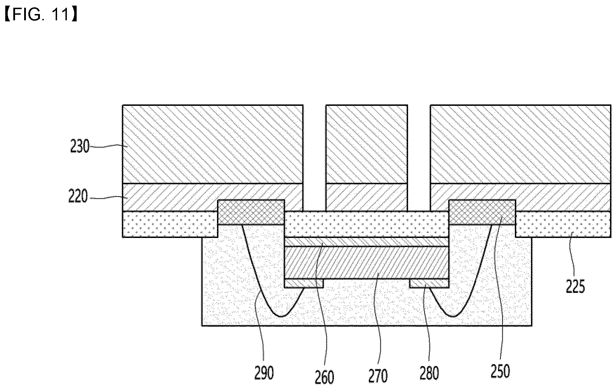

FIG. 11 is a view showing a chip package of the second embodiment.

Referring to FIG. 11, the chip package of the second embodiment may include the circuit board of FIG. 9 or FIG. 10.

The chip package of the second embodiment includes a surface treatment layer 250. The surface treatment layer 250 is formed on the lower surface of the first metal layer 220 vertically overlapping the opening 225T.

For example, the surface treatment layer 250 is disposed within the recess 220S of the first metal layer 220. The surface treatment layer 250 includes a first surface layer including nickel and a second surface layer including gold.

The chip package includes an adhesive layer 260 disposed on the lower surface of the oxide layer 225 of the circuit board.

An IC chip 270 is attached to the adhesive layer 260. The IC chip 270 includes a terminal 280. In addition, the terminal 280 of the IC chip 270 is electrically connected to a bonding portion of a circuit pattern layer (specifically, a surface treatment layer 250) through a connection member 290 such as a wire.

Meanwhile, the chip package includes a molding layer.

In the second embodiment, the insulating layer function of the circuit board is achieved by using only an oxide layer formed on the lower surface of the first metal layer.

The circuit board of the embodiment includes an insulating layer and a circuit pattern layer disposed on the insulating layer. The circuit pattern layer includes a first metal layer and a second metal layer. In addition, the second metal layer is a rolled alloy layer, and the first metal layer is a metal layer formed on one surface of the rolled alloy layer. At this time, an oxide layer is formed by oxidizing a surface of the first metal layer and formed at an interface between the first metal layer and the insulating layer. At this time, the oxide layer has a needle-like structure and can improve an adhesion between the first metal layer and the insulating layer.

Accordingly, the embodiment can solve the reliability problem of the circuit pattern layer including the first metal layer being peeled off from the insulating layer by improving the adhesion between the insulating layer and the first metal layer.

Furthermore, the embodiment can further improve the insulation characteristics of the circuit board by using the oxide layer disposed between the first metal layer and the insulating layer.

Meanwhile, the embodiment allows the second metal layer of the circuit pattern layer to be formed using an alloy including nickel (Ni)-chromium (Cr)-iron (Fe), and at least one metal selected from the group consisting of silver (Ag), silicon (Si), and alloys thereof. Accordingly, the second metal layer in the embodiment can have a certain level or higher of wear resistance, corrosion resistance, oxidation resistance and hardness. Through this, the embodiment can omit or remove a surface treatment layer that must be formed on the contact portion of the circuit pattern layer, thereby simplifying a manufacturing process of the circuit board and reducing a manufacturing cost.

Meanwhile, the first metal layer of the embodiment includes a recess formed in a region that vertically overlaps a through hole of the insulating layer. In addition, the recess can solve electrical reliability problem that occurs due to the oxide layer remaining on a bonding portion of the circuit pattern layer. Accordingly, the embodiment can improve electrical reliability of the circuit board and the chip package, and further improve product reliability.

In addition, the recess of the first metal layer can have a structure that penetrates the first metal layer. Accordingly, a lower surface of the second metal layer vertically overlapping the recess of the first metal layer can function as a bonding portion of the circuit pattern layer. At this time, the second metal layer of the circuit pattern layer in the embodiment can have a wire bonding property of a certain level or higher. Through this, the embodiment can omit or remove not only a surface treatment layer that must be formed on a contact portion of the circuit pattern layer, but also a surface treatment layer that must be formed on the bonding portion of the circuit pattern layer. Through this, the embodiment can further simplify the manufacturing process of the circuit board accordingly, and further reduce the manufacturing cost.

Furthermore, the embodiment can form an insulating layer using only an oxide layer formed on the lower surface of the first metal layer. That is, the embodiment allows the metal oxide layer to function as an insulating layer while removing the insulating layer of the organic material.

That is, the insulating layer of the circuit board of the embodiment can be formed only by the oxide layer formed on the lower surface of the first metal layer. Accordingly, the embodiment can further reduce a thickness of the circuit board by performing a function of the insulating layer using the oxide layer.

Furthermore, the embodiment can increase a thickness of the second metal layer of the circuit pattern layer by a thickness of the insulating layer of an organic material by removing the insulating layer of the organic material. At this time, the second metal layer is a rolled alloy layer. At this time, when the rolled alloy layer is manufactured to a thickness of 100 um or less, an additional rolling process is required, thereby increasing the manufacturing cost. Accordingly, the embodiment can omit the additional rolling process for reducing the thickness of the rolled alloy layer under a condition of not increasing a product thickness. Through this, the embodiment can simplify the manufacturing process of the circuit board, thereby reducing the manufacturing cost. Furthermore, the embodiment can improve overall bending characteristics of the circuit board by increasing the thickness of the second metal layer.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
a first metal layer; and
a second metal layer disposed on the first metal layer,
wherein the first metal layer includes an oxide layer formed by oxidizing a region at a predetermined depth from a lower surface of the first metal layer,
wherein the first metal layer and the second metal layer include a plurality of electrode patterns disposed on the oxide layer and spaced apart from each other, and
wherein the oxide layer insulates between the plurality of electrode patterns.

2. The circuit board of claim 1, further comprising:
an organic layer disposed under a lower surface of the oxide layer, and
wherein the organic layer functions as an insulating layer that insulates between the plurality of electrode patterns together with the oxide layer.

3. The circuit board of claim 1 or 2, wherein the second metal layer is an alloy layer containing nickel (Ni) and iron (Fe), and
wherein the first metal layer is a metal layer plated or deposited under a lower surface of the second metal layer

4. The circuit board of claim 3, wherein the second metal layer includes:
a first metal having a content in a range of 60 wt% to 80 wt%,
a second metal having a content in a range of 10 wt% to 22 wt%,
a third metal having a content in a range of 3 wt% to 20 wt%, and
a fourth metal having a content in a range of 3 wt% to 10 wt%,
wherein the first metal includes one of nickel (Ni) and iron (Fe),
wherein the second metal includes chromium (Cr),
wherein the third metal includes one of nickel (Ni) and iron (Fe), which is different from the first metal, and
wherein the fourth metal includes one of silver (Ag), silicon (Si), and a silver (Ag)-silicon (Si) alloy.

5. The circuit board of claim 4, wherein the first metal layer includes copper (Cu).

6. The circuit board of claim 1, wherein a total thickness of the first metal layer including the oxide layer is in a range of 7 um to 15 um,
wherein a thickness of the oxide layer in the first metal layer is in a range of 3 um to 5 um, and
wherein a thickness of the second metal layer is in a range of 100 um to 200 um.

7. The circuit board of claim 2, wherein a total thickness of the first metal layer including the oxide layer is in a range of 2 um to 10 um,
wherein a thickness of the oxide layer in the first metal layer is in a range of 0.2 um to 5 um, and
wherein a thickness of the second metal layer is in a range of 20 um to 50 um.

8. The circuit board of claim 1 or 2, wherein the oxide layer includes at least one opening,
wherein the first metal layer includes a first region vertically overlapping the opening, and a second region excluding the first region,
wherein a recess is formed in the first region of the first metal layer and connected to the opening, and
wherein a thickness of the first region of the first metal layer is smaller than a thickness of the second region of the first metal layer.

9. The circuit board of claim 8, wherein the second metal layer includes a third region vertically overlapping the opening and the recess, and a fourth region excluding the third region,
wherein the recess penetrates upper and lower surfaces of the first metal layer, and
wherein a lower surface of the third region of the second metal layer is exposed without contacting the first metal layer and the oxide layer.

10. The circuit board of claim 2, further comprising:
a first adhesive layer disposed between the oxide layer and the organic layer,
wherein the organic layer includes at least one through hole, and
wherein the first adhesive layer includes an open region vertically overlapping the through hole.
